# EUROPEAN PATENT APPLICATION

(11) **EP 4 462 018 A1**
(43) Date of publication of application: **13.11.2024**
(21) Application number: 23735164.8
(22) Date of filing: 03.01.2023
(51) Int. Cl.: F21V 21/14, F21S 2/00, H01L 25/075, H01L 33/36, G09F 9/33, H01L 27/15, H05B 45/10, H05B 47/10, F21Y 115/10

(54) **LIGHT EMITTING DEVICE**

(30) Priority: 03.01.2022 US 202263296012 P; 14.10.2022 US 202263416276 P; 29.12.2022 US 202218148381
(71) Applicant: Seoul Semiconductor Co., Ltd., Gyeonggi-do 15429 (KR)
(72) Inventor: CHO, Hong Suk, Ansan-si Gyeonggi-do 15429 (KR)
(74) Representative: Isarpatent
(86) International application number: PCT/KR2023/000079
(87) International publication number: WO 2023/128732

(57) **Abstract**

A light emitting device includes: a main body; a main light emitting module which is disposed on the main body and generates light; a tilting module including a tilting frame which has a first frame part and a second frame part forming an angle with each other, and is disposed on one side of the main light emitting module; a first auxiliary light emitting module disposed on the first frame part to generate light; and a second auxiliary light emitting module disposed on the second frame part to generate light.

## Description

### TECHNICAL FIELD

The present invention relates to a light emitting device.

### BACKGROUND ART

In general, a light emitting device is a device that emits light. The light emitting device is also used for a tail lamp of a vehicle or a display such as a billboard. The light emitting device may be used as a display by implementing an image through a plurality of light emitting elements.

A conventional light emitting device is configured by disposing a plurality of light emitting elements on a plate-shaped substrate. The light emitting device implements various colors using blue, green, red and mixed colors thereof. In the conventional light emitting device, the light emitting direction could not be changed, and the irradiation angle of the light emitting device is limited. In addition, in the conventional light emitting device, there occurs a deviation in light amount depending on the viewing angle and the light could not be irradiated in three dimensions. In addition, in the conventional light emitting device, as each control unit is configured for each pixel or each module, there has arisen probems that the configuration of the circuit becomes complicated, and a single user interface cannot be provided.

### DETAILED DESCRIPTION OF INVENTION

### TECHNICAL PROBLEMS

In view of the above, embodiments of the present invention provides a light emitting device capable of three-dimensionally irradiating light with a small deviation in illuminance depending on the viewing angle and excellent visibility. Further, they provides a light emitting device capable of being simplified configuration of a controller of a device and a circuit and providing a single user interface to a user by controlling each pixel or each module through one controller.

### TECHNICAL SOLUTION

In accordance with one aspepct of the present invention, there may be provided a light emitting device including: a main body; a main light emitting module which is disposed on the main body and generates light; a tilting module including a tilting frame which has a first frame part and a second frame part forming an angle with each other, and is disposed on one side of the main light emitting module; a first auxiliary light emitting module disposed on the first frame part to generate light; and a second auxiliary light emitting module disposed on the second frame part to generate light.

Further, the main light emitting module may include a main light emission substrate disposed on the main body and one or more main light emitting elements disposed on the main light emission substrate.

Further, the main light emitting module may include a plurality of main light emitting modules, and a non-emission area where no light is generated may be formed between the plurality of main light emitting modules.

Further, the one or more main light emitting elements may include a plurality of main light emitting structures and a main light emission electrode, each of the plurality of main light emitting structures may include one or more conductive-type semiconductor layer and an electrode layer, and the main light emission electrode may be electrically connected to the electrode layer included in each of the plurality of main light emitting structures.

Further, the first auxiliary light emitting module may include a first auxiliary light emission substrate disposed on the first frame part, and one or more first auxiliary light emitting elements disposed on the first auxiliary light emission substrate.

Further, the one or more first auxiliary light emitting elements may be configured to generate light of a different wavelength from that of the one or more main light emitting elements included in the main light emitting module, or configured to have a different lamination structure from that of the one or more main light emitting elements.

Further, the second auxiliary light emitting module includes a second auxiliary light emission substrate disposed on the second frame part, and one or more second auxiliary light emitting elements disposed on the second auxiliary light emission substrate.

Further, the tilting module may further include a rotation driving unit configured to provide a driving force for rotating the tilting frame, the rotation driving unit may include a rotation shaft extending in a direction orthogonal to an imaginary line perpendicular to a central portion of the first frame part and an imaginary line perpendicular to a central portion of the second frame part, and the rotation driving unit may be configured to rotate the tilting frame about the rotation shaft.

Further, when viewed from a front side, a width of the tilting module in a left-right direction may be smaller than a width of the main light emitting module in the left-right direction.

Further, the light emitting device may further include a controller for controlling at least one of the main light emitting module, the first auxiliary light emitting module, the second auxiliary light emitting module to emit light, or controlling the rotation driving unit to rotate the tilting frame.

Further, the controller may control the tilting module so that the tilting frame is positioned in a first position state in which a front surface of the first frame part and a front surface of the second frame part each form an inclination angle with a front surface of the main light emitting module, a second position state in which one of the front surface of the first frame part and the front surface of the second frame part is parallel to the front surface of the main light emitting module, or a third position state in which the other one of the front surfaces of the first frame part and the front surface of the second frame part is parallel to the front surface of the main light emitting module.

Further, in the first position state, the inclination angle between the front surface of the first frame part and the front surface of the main light emitting module and the inclination angle between the front surface of the second frame part and the front surface of the main light emitting module may be smaller than an angle formed by the front surface of the first frame part and the front surface of the second frame part.

Further, in the first position state, a connection portion of the first frame part and the second frame part may be protruded forward or retracted backward by a predetermined distance from an imaginary reference line extending from the front surface of the main light emitting module to the connection portion of the first frame part and the second frame part.

In accordance with another aspect of the present invention, there may be provided a light emitting device including: a main body; a main light emitting module which is disposed on the main body and generates light; a tilting module including a tilting frame which has a first frame part and a second frame part forming an angle with each other, and is disposed on one side of the main light emitting module; an auxiliary light emitting module disposed on one of the first frame part and the second frame part to emit light; and a reflection module disposed on the other one of the first frame part and the second frame part to reflect light.

Further, the auxiliary light emitting module may include an auxiliary light emission substrate disposed on one of the first frame part and the second frame part, and one or more auxiliary light emitting elements disposed on the auxiliary light emission substrate.

Further, the light emitting device may further include a reflection light emitting module disposed on the main body to irradiate light to the reflection module.

Further, the tilting module may further include a rotation driving unit configured to provide a driving force for rotating the tilting frame, and the light emitting device may further include a controller for controlling at least one of the main light emitting module and the auxiliary light emitting module to emit light, or controlling the rotation driving unit to rotate the tilting frame.

In accordance with still another aspect of the present invention, there may be provided a light emitting device including: a main body; a main light emitting module which is disposed on the main body and generates light; a tilting module including a tilting frame which has a first frame part and a second frame part forming an angle with each other, and is disposed on one side of the main light emitting module; and a reflection module disposed on each of the first frame part and the second frame part to reflect light.

Further, the light emitting device may further include a reflection light emitting module disposed on the main body to irradiate light to the reflection module.

Further, the tilting module may further include a rotation driving unit configured to provide a driving force for rotating the tilting frame, and the light emitting device may further include a controller for controlling the main light emitting module to emit light, or controlling the rotation driving unit to rotate the tilting frame.

### EFFECT OF INVENTION

According to the embodiments of the present invention, the irradiation angle of light can be variously changed.

In addition, according to the embodiments of the present invention, the deviation of illumination depending on the viewing angle is small, the visibility is good, and light can be irradiated in three dimensions.

Further, according to embodiments of the present invention, since a plurality of pixels or a plurality of modules can be controlled using one user interface, there is an advantage in that the display device or the lighting device can be controlled without restrictions on the size or distance.

Furthermore, by controlling each pixel or each module through one controller without configuring each controller for each pixel or each module, the configuration of the controller of the device can be simplified and the configuration of the circuit can be simplified.

### BRIEF DESCRIPTION OF THE DRAWINGS

FIG. 1 is a view showing a light emitting device according to a first embodiment of the present invention viewed from one direction.
FIG. 2 is a plan view of a main light emitting module of the light emitting device according to the first embodiment of the present invention.
FIG. 3 is a cross-sectional view of the main light emitting module of the light emitting device according to the first embodiment of the present invention.
FIG. 4 is a view showing a light emitting device according to a second embodiment of the present invention viewed from one direction.
FIG. 5 is a plan view of first and second auxiliary light emitting modules of the light emitting device according to the second embodiment of the present invention.
FIG. 6 is a cross-sectional view of first and second auxiliary light emitting modules of the light emitting device according to the second embodiment of the present invention.
FIG. 7 is a view showing a light emitting device according to a third embodiment of the present invention viewed from one direction.
FIG. 8 is a view showing a light emitting device according to the third embodiment of the present invention viewed from another direction.
FIGS. 9 and 10 are views showing the operation of the light emitting device according to the third embodiment of the present invention.
FIG. 11 is a view showing a light emitting device according to a fourth embodiment of the present invention viewed from another direction.
FIG. 12 is a view showing a light emitting device according to a fifth embodiment of the present invention viewed from another direction.
FIG. 13 is a plan view of a main light emitting module of a light emitting device according to a sixth embodiment of the present invention.
FIG. 14 is a cross-sectional view of a main light emitting module of a light emitting device according to a sixth embodiment of the present invention.
FIG. 15 is a cross-sectional view of a main light emitting module of a light emitting device according to a seventh embodiment of the present invention.
FIG. 16 is a cross-sectional view of a main light emitting module of a light emitting device according to an eighth embodiment of the present invention.
FIG. 17 is a plan view of a first auxiliary light emitting module of the light emitting device according to the ninth embodiment of the present invention.
FIG. 18 is a cross-sectional view of the first auxiliary light emitting module of a light emitting device according to a ninth embodiment of the present invention.
FIG. 19 is a cross-sectional view of a first auxiliary light emitting module of a light emitting device according to a tenth embodiment of the present invention.
FIG. 20 is a cross-sectional view of a second auxiliary light emitting module of a light emitting device according to an eleventh embodiment of the present invention.
FIG. 21 is a plan view of a second auxiliary light emitting module of a light emitting device according to a twelfth embodiment of the present invention.
FIG. 22 is a cross-sectional view of the second auxiliary light emitting module of the light emitting device according to the twelfth embodiment of the present invention.
FIG. 23 is a cross-sectional view of a second auxiliary light emitting module of a light emitting device according to a thirteenth embodiment of the present invention.
FIG. 24 is a cross-sectional view of a second auxiliary light emitting module of a light emitting device according to a fourteenth embodiment of the present invention.
FIG. 25 is a view showing a light emitting device according to a fifteenth embodiment of the present invention viewed from one direction.
FIG. 26 is a view showing the light emitting device according to the fifteenth embodiment of the present invention viewed from another direction.
FIG. 27 is a view showing a light emitting device according to a sixteenth embodiment of the present invention viewed from one direction.
FIG. 28 is a view showing the light emitting device according to the sixteenth embodiment of the present invention viewed from another direction.
FIGS. 29 to 31 are views respectively showing light emitting devices according to a seventeenth embodiment of the present invention viewed from one direction.
FIG. 32 is a view showing a light emitting device according to an eighteenth embodiment of the present invention viewed from one direction.

### BEST MODE FOR CARRYING OUT THE INVENTION

Hereinafter, specific embodiments for implementing a spirit of the present invention will be described in detail with reference to the drawings.

In describing the present invention, detailed descriptions of known configurations or functions may be omitted to clarify the present invention.

When an element is referred to as being 'connected' to, 'supported' by, 'accessed' to, 'supplied' to, 'transferred' to, or 'contacted' with another element, it should be understood that the element may be directly connected to, supported by, accessed to, supplied to, transferred to, or contacted with another element, but that other elements may exist in the middle.

The terms used in the present invention are only used for describing specific embodiments, and are not intended to limit the present invention. Singular expressions include plural expressions unless the context clearly indicates otherwise.

Further, in the present invention, it is to be noted that expressions, such as up and down direction, left and right direction, upper side, lower side, left side, right side, front side, and rear side are described based on the illustration of drawings, but may be modified if directions of corresponding objects are changed. For the same reasons, some components are exaggerated, omitted, or schematically illustrated in the accompanying drawings, and the size of each component does not fully reflect the actual size.

Terms including ordinal numbers, such as first and second, may be used for describing various elements, but the corresponding elements are not limited by these terms. These terms are only used for the purpose of distinguishing one element from another element.

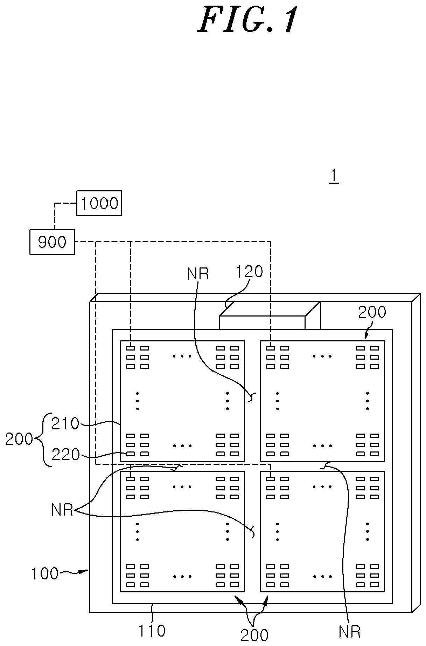

In the present specification, it is to be understood that the terms such as "including" are intended to indicate the existence of the certain features, areas, integers, steps, actions, elements, combinations, and/or groups thereof disclosed in the specification, and are not intended to preclude the possibility that one or more other certain features, areas, integers, steps, actions, elements, combinations, and/or groups thereof may exist or may be added. Hereinafter, a specific configuration of a light emitting device according to a first embodiment of the present invention will be described with reference to FIGS. 1 to 3.

Referring to FIG. 1, the light emitting device 1 according to the first embodiment of the present invention can generate light by receiving power from the outside. The light emitting device 1 may include a main body 100, a main light emitting module 200, a controller 900, and a user interface 1000.

The main body 100 may be a single member or an assembly of a plurality of members which supports the main light emitting module 200 and the tilting module 300. The main body 100 may be at least a part of a device that radiates light, such as a main body of a tail lamp of a vehicle, a main body of an indoor or outdoor billboard, or a main body of a display, for example. The main body 100 may support the main light emitting module 200. The main body 100 may include a main light emitting module support member 110 and a fixing bracket 120.

The main light emitting module support member 110 may be a member that supports a plurality of main light emitting modules 200. The main light emitting module support member 110 may be supported by the fixing bracket 120. The main light emitting module support member 110 may have a plate shape, but is not necessarily limited thereto.

The fixing bracket 120 may be a bracket supporting the main light emitting module support member 110. The fixing bracket 120 may be disposed on a rear surface of the main light emitting module support member 110. In addition, the fixing bracket 120 may have a width in a left-right direction smaller than that of the main light emitting module support member 110 or a width in an up-down direction smaller than that of the main light emitting module support member 110.

The main light emitting module 200 may be a module that generates light. The main light emitting module 200 may be fixed to the main body 100 so as not to rotate with respect to the main body 100. The number of main light emitting modules 200 may be plural. When the main light emitting module 200 is provided in plurality, the plurality of main light emitting modules 200 may be disposed spaced apart from each other on the main light emitting module support member 110, and the plurality of main light emitting modules 200 may be arranged in a lattice shape. The main light emitting module 200 may include a main light emission substrate 210, one or more main light emitting elements 220, and a main light emission electrode 230.

The main light emission substrate 210 may be a substrate for fixing the main light emitting elements 220. The main light emission substrate 210 may be provided in plurality. The plurality of main light emission substrates 210 may be oriented in a main direction so that the main light emitting elements 220 emit light in a predetermined direction, and may be fixed to the main light emitting module support member 110 of the main body 100. The main light emission substrate 210 may be a printed circuit board or a flexible printed circuit board.

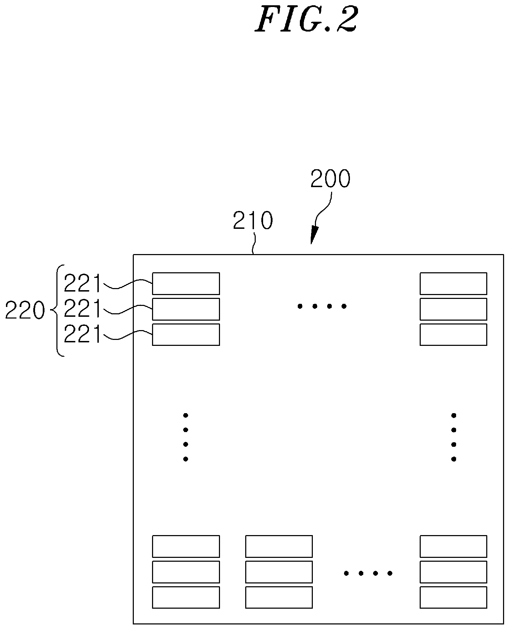

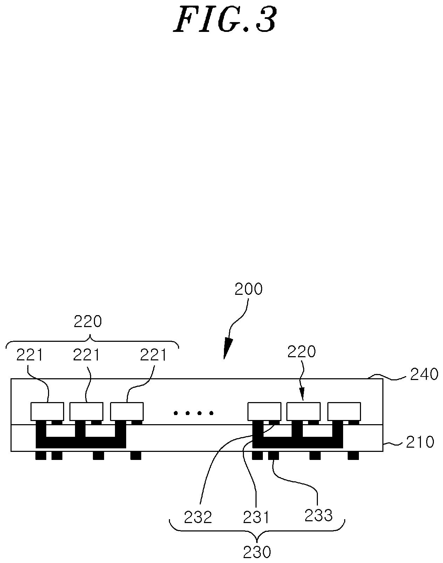

Referring to FIGS. 2 and 3, one or more main light emitting elements 220 may be disposed on the main light emission substrate 210 to generate light. A plurality of the main light emitting elements 220 may be disposed on the main light emission substrate 210. Each of the plurality of main light emitting elements 220 may individually generate light. In other words, each of the plurality of main light emitting elements 220 may be configured to emit the same light, but may be configured to emit light with different brightness at different times. In addition, the plurality of main light emitting elements 220 may be operated to blink at the same time or to generate light sequentially, or only some of them may generate light to implement characters, pictures, or the like.

The plurality of main light emitting elements 220 are spaced apart from each other on one main light emission substrate 210, so that a non-emission area NR where no light is generated may be provided between the plurality of main light emitting elements 220. A distance between the plurality of main light emitting elements 220 may be greater than a distance between the main light emitting structures 221 in one main light emitting element 220. Heat generated from each of the main light emitting elements 220 is dissipated through a space between the main light emitting elements 220 spaced apart from each other, so that the main light emitting structure 221 can be prevented from being damaged by excessive heat. The plurality of main light emitting elements 220 may be arranged at a predetermined interval in a lattice shape on the main light emission substrate 210. When the plurality of main light emitting elements 220 are arranged in the lattice shape, rows and columns of the lattice shape may be arranged in parallel in the left-right direction and in the up-down direction of the main light emission substrate 210, respectively. The main light emitting element 220 may include a plurality of main light emitting structures 221.

The main light emitting structure 221 may include first and second conductivity-type semiconductor layers, an active layer, an electrode layer, and an insulating layer. The first and second conductivity-type semiconductor layers, the active layer, the electrode layer, and the insulating layer may form a laminated structure. The first conductivity-type semiconductor layer may include n-type impurities, and the second conductivity-type semiconductor layer may include p-type impurities. The active layer may include a multi-quantum well structure, and the composition ratio of the nitride-based semiconductor may be adjusted to emit a desired wavelength. For example, the active layer may emit red light, green light, blue light, or ultraviolet light depending on the semiconductor materials forming the layer and the composition ratio thereof.

When a plurality of main light emitting structures 221 are provided, the plurality of main light emitting structures 221 may be configured to individually emit light. In addition, the plurality of main light emitting structures 221 may be arranged side by side in a horizontal direction on the main light emission substrate 210. Meanwhile, the idea of the present invention is not limited to the types of colors generated by the plurality of main light emitting structures 221. In other words, all of the plurality of main light emitting structures 221 included in one main light emitting element 220 may emit light of the same color, some of them may emit light of the same color while the others emit light of different colors, or they may emit lights of different colors, respectively. Alternatively, each of the plurality of main light emitting structures 221 may have a structure in which a plurality of active layers are vertically laminated to emit lights of different colors. An ohmic layer may make ohmic contact with the first conductivity-type semiconductor layer or the second conductivity-type semiconductor layer. The contact layer may be electrically connected to the ohmic layer and the electrode layer. The contact layer may include a plurality of contact pads. The electrode layer may be electrically connected to the contact layer and the main light emission electrode 230.

The main light emission electrode 230 may transmit electricity to one or more main light emitting elements 220. The main light emission electrode 230 may be formed of an electrically conductive material. The main light emission electrode 230 may include a common electrode 231 for main light emission, a plurality of individual electrodes 232 for main light emission, and a plurality of external connection electrodes 233 for main light emission.

The main light emission common electrode 231 may be connected to a cathode of each of the plurality of main light emitting structures 221 forming a single main light emitting element 220. Each of the plurality of main light emission individual electrodes 232 may be respectively connected to an anode of each of the plurality of main light emitting structures 221. The plurality of main light emission external connection electrodes 233 may be configured to electrically connect the main light emission common electrode 231 and the main light emission individual electrode 232 to a power supply outside the main light emitting module 200.

The main light emission filling material 240 may cover the plurality of main light emitting structures 221. The main light emission filling material 240 may be disposed on one main light emission substrate 210 to cover the plurality of main light emitting elements 220. The main light emission filling material 240 may be formed of a material through which light can transmit. The main light emission filling material 240 can prevent the main light emitting structure 221 from being shifted from its original position, and can protect the main light emitting structure 221 from external foreign substances.

Each of the plurality of main light emitting modules 200 may include at least one controller (not shown), for example, an IC chip. At least one controller may receive an input value and control the main light emitting module 200 to display a resultant value according to the input value in a display or lighting method.

The controller included in each main light emitting module 200 may be connected to and controlled by one controller 900. Further, the controller 900 may receive an input value from the user through the user interface 1000 provided to the user.

The input value may be on, off, flashing, partially lit, partially unlit, partially flashing, color temperature control, brightness control, a user-programmed drive pattern, or an arbitrarily set drive pattern, and the like, and depending on the input value, at least one pixel or at least one light emitting module may be controlled.

The driving pattern programmed by the user or arbitrarily set driving pattern is not limited to, for example, numbers, letters, figures, pictures, emoticons, and driving patterns created by the user.

A user may control a plurality of pixels or a plurality of modules of the plurality of main light emitting modules 200 by using the user interface 1000. The user interface 1000 may be an application of a smart device or an in-vehicle setting tool. Accordingly, the user may control the main light emitting module 200 without being restricted by the size of the main body 100 supporting the main light emitting module 200 or the distance between the main body 100 and the user.

The light emitting device 1 according to the first embodiment of the present invention is configured to control each pixel or each module through one controller 900 without configuring each control unit for each pixel or each module. Accordingly, the configuration of the control unit 900 of the light emitting device 1 can be simplified and the configuration of the circuit can be simplified.

The controller 900 may be an encoding processor of a general-purpose computer, a special purpose computer, or other programmable data processing equipment, and computer program instructions for controlling the operation of the light emitting device 1 may be loaded in the controller 900. Further, computer program instructions may be stored in computer usable or computer readable memory.

The light emitting device 1 according to the first embodiment of the present invention is applied to a display or lighting provided inside or outside a vehicle, and may be interlocked with a source (GPS, camera, radar, lidar, ultrasonic sensor, etc.) for recognizing an external environment, and the result value according to the input value input by the source can be expressed through display and lighting.

For example, when an external vehicle approaches the user's vehicle and arises a possibility of being exposed to danger, the vehicle recognizes the external environment and transmits a signal, and the controller receives the input value and expresses it as an indoor display and lighting, so that the user can detect risks and be able to deal with them.

In addition, the color of light emitted from the light emitting device 1 may be changed so that it is recognized that the vehicle is in an autonomous driving state. In this case, the color of light emitted from the light emitting device 1 may be automatically changed in conjunction with the vehicle system or manually through the user interface 1000.

Further, the light emitting device 1 may be implemented as a display or lighting including cyan color so that the user or the outside can recognize that the vehicle is in an autonomous driving state. In addition, in a situation where interaction with another vehicle is required, such as a lane change, the user's psychological state or mind can be expressed to the other party through the light emitting device 1.

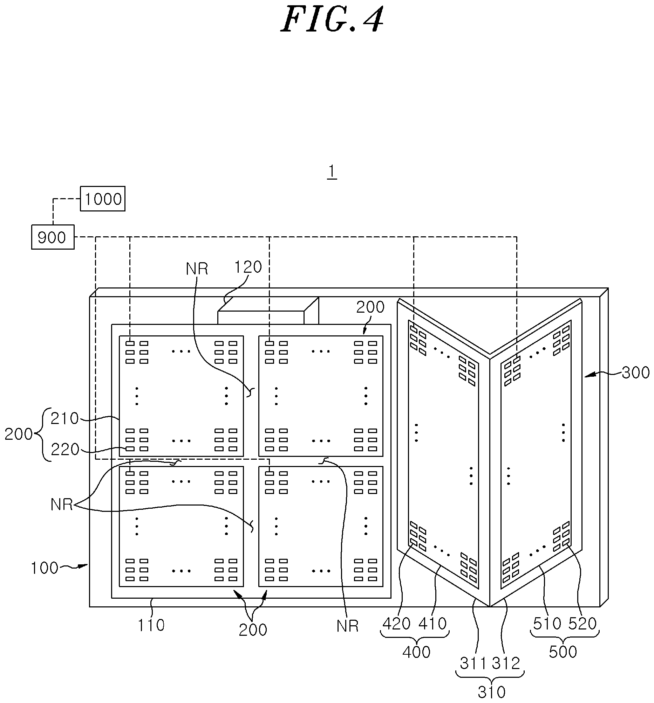

Hereinafter, a second embodiment will be described with reference to FIGS. 4 to 6. In describing the second embodiment of the present invention, differences from the first embodiment will be mainly described, and the same description and reference numerals refer to the above-described embodiments.

Compared to the light emitting device according to the first embodiment, the light emitting device according to the second embodiment of the present invention may further include a tilting module and an auxiliary light emitting module. Referring to FIG. 4, the light emitting device 1 according to the first embodiment may include a main body 100, a main light emitting module 200, a tilting module 300, and a controller 900, and include at least one of a first auxiliary light emitting module 400 and a second auxiliary light emitting module 500.

The main body 100 may support the main light emitting module 200 and the tilting module 300. The tilting module 300 may be disposed adjacent to the main body 100 to support the auxiliary light emitting modules 400 and 500. When the tilting module 300 is viewed from the front, the width of the tilting module 300 in the left-right direction may be smaller than the width of the main light emitting module 200 in the left-right direction. The tilting module 300 may include a tilting frame 310.

The tilting frame 310 may be a frame supporting the plurality of auxiliary light emitting modules 400 and 500. The tilting frame 310 is disposed on one side of the main light emitting module 200. In addition, the tilting frame 310 may include a first frame part 311 and a second frame part 312 which form an angle with each other. The first frame part 311 and the second frame part 312 of the tilting frame 310 are formed so that a central portion of one member is bent at an angle, or the two members may be spaced apart and oriented at an angle with respect to each other. For example, the first frame part 311 and the second frame part 312 may be connected at an angle between 60 degrees and 150 degrees with respect to each other.

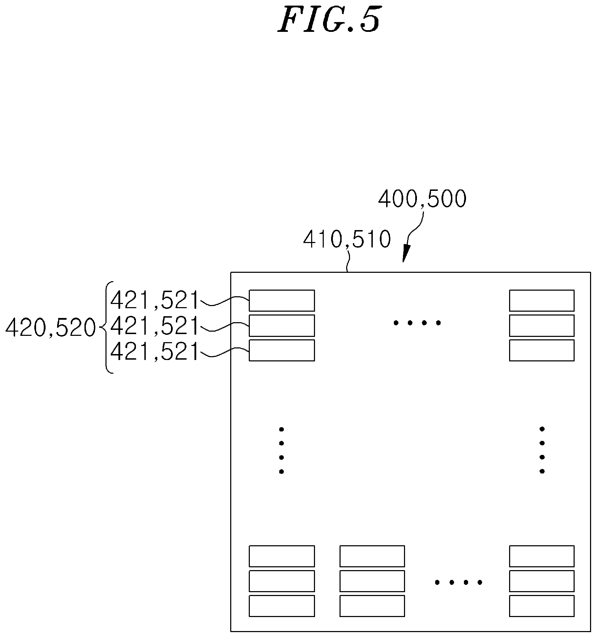

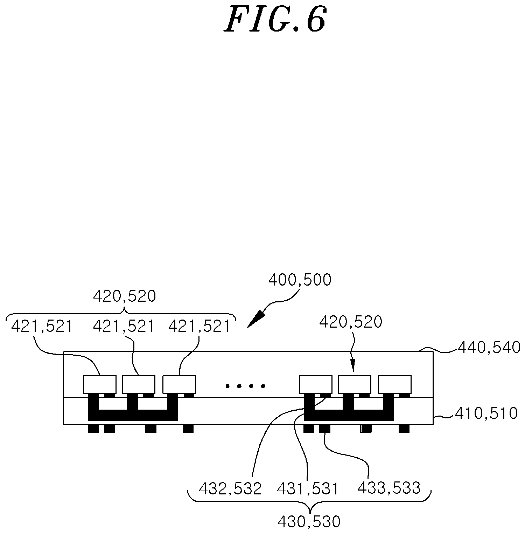

Referring to FIGS. 5 and 6, the first auxiliary light emitting module 400 may be a module disposed on one side of the tilting frame 310 to emit light. The first auxiliary light emitting module 400 may generate light independently of the above-described main light emitting module 200. In other words, even when the main light emitting module 200 emits light, the first auxiliary light emitting module 400 may not emit light, and vice versa. The first auxiliary light emitting module 400 is disposed on the first frame part 311 of the tilting frame 310 to emit light. The first auxiliary light emitting module 400 includes a first auxiliary light emission substrate 410 and one or more first auxiliary light emitting elements 420.

The first auxiliary light emission substrate 410 may be a substrate for fixing the first auxiliary light emitting element 420. The first auxiliary light emission substrate 410 may include a plurality of first auxiliary light emission substrates 410, and the plurality of first auxiliary light emission substrates 410 may be oriented in a first auxiliary direction that is different from the main direction in which the main light emission substrate 210 is oriented so that the first auxiliary light emitting element 420 emits light in a direction different from that of the main light emitting element 220. The first auxiliary light emission substrate 410 may be a printed circuit board or a flexible printed circuit board.

One or more first auxiliary light emitting elements 420 may be disposed on the first auxiliary light emission substrate 410 to generate light. The first auxiliary light emitting element 420 may be configured to generate light of a different wavelength from that of the main light emitting element 220 or may have a different lamination structure from that of the main light emitting element 220. A plurality of the first auxiliary light emitting elements 420 may be disposed on the first auxiliary light emission substrate 410. Each of the plurality of first auxiliary light emitting elements 420 may individually generate light. In other words, the plurality of first auxiliary light emitting elements 420 may be configured to emit the same light, but may also be configured to emit lights with different brightness at different times. In addition, the plurality of first auxiliary light emitting elements 420 may be operated to blink simultaneously or to generate light sequentially, or only some of them may generate light to implement characters, pictures, or the like. The one or more first auxiliary light emitting elements 420 may be configured to generate light different from that of the main light emitting element 220.

The plurality of first auxiliary light emitting elements 420 are disposed spaced apart from each other on the first auxiliary light emission substrate 410 so that a non-emission area NR where no light is generated may be provided between the plurality of first auxiliary light emitting elements 420, and a distance between the plurality of first auxiliary light emitting elements 420 may be greater than a distance between the first auxiliary light emitting structures 421 within one first auxiliary light emitting device 420. Heat generated from each of the first auxiliary light emitting elements 420 is dissipated through the space between the first auxiliary light emitting elements 420 spaced apart from each other, so that the first auxiliary light emitting structure 421 can be prevented from being damaged by excessive heat. The plurality of first auxiliary light emitting elements 420 may be spaced apart from each other at a predetermined interval in a lattice shape on the first auxiliary light emission substrate 410. When the plurality of first auxiliary light emitting elements 420 are arranged in the lattice shape, rows and columns of the lattice shape may be arranged parallel to each other in the left-right direction and in the up-down direction of the first auxiliary light emission substrate 410, respectively. The first auxiliary light emitting element 420 may include the plurality of first auxiliary light emitting structures 421.

When the plurality of first auxiliary light emitting structures 421 are provided as described above, each of the plurality of first auxiliary light emitting structures 421 may be configured to individually generate light. In addition, the plurality of first auxiliary light emitting structures 421 may be arranged side by side in the horizontal direction on the first auxiliary light emission substrate 410. All of the plurality of first auxiliary light emitting structures 421 included in one first auxiliary light emitting element 420 may emit light of the same color, or some of them may emit light of the same color while the others emit light of a different color, or they may respectively emit lights of different colors. Alternatively, each of the plurality of first auxiliary light emitting structures 421 may have a structure in which a plurality of active layers capable of emitting lights of different colors are vertically laminated.

A first auxiliary light emission electrode 430 may transmit electricity to the one or more first auxiliary light emitting elements 420. The first auxiliary light emission electrode 430 may be formed of an electrically conductive material. The first auxiliary light emission electrode 430 may include a common electrode 431 for first auxiliary light emission, a plurality of individual electrodes 432 for first auxiliary light emission, and a plurality of external connection electrodes 433 for first auxiliary light emission.

The first auxiliary light emission common electrode 431 may be connected to a cathode of each of the plurality of first auxiliary light emitting structures 421 forming a single first auxiliary light emitting element 420. Each of the plurality of auxiliary light emission individual electrodes 432 is connected to an anode of each of the plurality of first auxiliary light emitting elements 420. The plurality of first auxiliary light emission external connection electrodes 433 may be configured to electrically connect each of the first auxiliary light emission common electrodes 431 and the first auxiliary light emission individual electrodes 432 to a power supply outside the first auxiliary light emitting module 400.

A first auxiliary light emission filling material 440 may cover the plurality of first auxiliary light emitting structures 421. The first auxiliary light emission filling material 440 may be formed of a material through which light can transmit. The first auxiliary light emission filling material 440 can prevent the first auxiliary light emitting structure 421 from being shifted from its original position and can protect the first auxiliary light emitting structure 421 from external foreign substances.

Referring to FIGS. 5 and 6, the second auxiliary light emitting module 500 may be a module disposed on the other side of the tilting frame 310 to emit light. The second auxiliary light emitting module 500 may generate light independently of the above-described main light emitting module 200 and the first auxiliary light emitting module 400. In other words, even when at least one of the main light emitting module 200 and the first auxiliary light emitting module 400 emits light, the second auxiliary light emitting module 500 may not emit light, and vice versa. The second auxiliary light emitting module 500 is disposed on the second frame part 312 of the tilting frame 310 to emit light. The first auxiliary light emitting module 400 and the second auxiliary light emitting module 500 may be symmetrically arranged with respect to the center of the tilting frame 310. The second auxiliary light emitting module 500 includes a second auxiliary light emission substrate 510 and one or more second auxiliary light emitting elements 520.

The second auxiliary light emission substrate 510 may be a substrate for fixing the second auxiliary light emitting elements 520. The auxiliary light emission substrate 510 may include a plurality of auxiliary light emission substrates 510, and the plurality of auxiliary light emission substrates 510 may be oriented in a second auxiliary direction that is different from the main direction in which the main light emission substrate 210 is oriented and the first auxiliary direction in which the first auxiliary light emission substrate 410 is oriented, so that the second auxiliary light emitting elements 520 emit light in a direction different from that of the main light emitting element 220 and that of the first auxiliary light emitting element 420. The second auxiliary light emission substrate 510 may be a printed circuit board or a flexible printed circuit board.

The one or more second auxiliary light emitting elements 520 may be disposed on the second auxiliary light emission substrate 510 to generate light. The second auxiliary light emitting elements 520 may be configured to generate light of a different wavelength from the main light emitting element 220 or the first auxiliary light emitting element 420, or may have a different lamination structure from that of the main light emitting element 220 or the first auxiliary light emitting element 420. The plurality of second auxiliary light emitting elements 520 may be disposed on the second auxiliary light emission substrate 510. Each of the plurality of second auxiliary light emitting elements 520 may individually generate light. In other words, the plurality of second auxiliary light emitting elements 520 may be configured to emit the same light, but may also be configured to emit lights with different brightness at different times. In addition, the plurality of second auxiliary light emitting elements 520 may be operated to blink simultaneously or to generate light sequentially, or only some of them may generate light implement characters, pictures, or the like. The one or more second auxiliary light emitting elements 520 may be configured to generate light different from that of the main light emitting element 220.

The plurality of second auxiliary light emitting elements 520 are spaced apart from each other on the auxiliary light emission substrate 510 so that a non-emission area NR where no light is generated may be provided between the plurality of second auxiliary light emitting elements 520, and a distance between the plurality of second auxiliary light emitting elements 520 may be greater than a distance between the second auxiliary light emitting structures 521 within one second auxiliary light emitting element 520. Heat generated from each of the second auxiliary light emitting elements 520 is dissipated through the space in which the second auxiliary light emitting elements 520 spaced apart from each other, so that the second auxiliary light emitting structure 521 can be prevented from being damaged by excessive heat. The plurality of second auxiliary light emitting elements 520 may be spaced apart from each other at a predetermined interval in a lattice shape on the auxiliary light emission substrate 510. When the plurality of second auxiliary light emitting elements 520 are arranged in the lattice shape, rows and columns of the lattice shape may be arranged in parallel in the left-right direction and in the up-down direction of the second auxiliary light emission substrate 510, respectively. In addition, the plurality of second auxiliary light emitting elements 520 may be arranged on the second auxiliary light emission substrate 510 in a pattern different from the pattern in which the plurality of first auxiliary light emitting elements 420 are arranged on the first auxiliary light emission substrate 410 described above. The second auxiliary light emitting device 520 may include a plurality of second auxiliary light emitting structures 521.

When the plurality of second auxiliary light emitting structures 521 are provided as described above, each of the plurality of second auxiliary light emitting structures 521 may be configured to individually emit light. Further, the plurality of second auxiliary light emitting structures 521 may be arranged side by side in the horizontal direction on the second auxiliary light emission substrate 510. All of the plurality of second auxiliary light emitting structures 521 included in one second auxiliary light emitting element 520 may emit light of the same color, or some of them may emit light of the same color while the others emit light of a different color, or they may respectively emit lights of different colors.

A second auxiliary light emission electrode 530 may transmit electricity to the one or more second auxiliary light emitting elements 520. The second auxiliary light emission electrode 530 may be formed of an electrically conductive material. The second auxiliary light emission electrode 530 may include a common electrode 531 for second auxiliary light emission, a plurality of individual electrodes 532 for second auxiliary light emission, and a plurality of external connection electrodes 533 for second auxiliary light emission.

The second auxiliary light emission common electrode 531 may be connected to a cathode of each of the plurality of second auxiliary light emitting structures 521 forming a single second auxiliary light emitting element 520. Each of the plurality of second auxiliary light emission individual electrodes 532 is connected to an anode of each of the plurality of second auxiliary light emitting elements 520. The plurality of second auxiliary light emission external connection electrodes 533 may be configured to electrically connect each of the second auxiliary light emission common electrode 531 and the second auxiliary light emission individual electrode 532 to a power supply outside the second auxiliary light emitting module 500.

A second auxiliary light emission filling material 540 may cover the plurality of second auxiliary light emitting structures 521. The second auxiliary light emission filling material 540 may be formed of a material through which light can transmit. The second auxiliary light emission filling material 540 can prevent the second auxiliary light emitting structure 521 from being shifted from its original position and can protect the second auxiliary light emitting structure 521 from external foreign substances.

The controller 900 may control light emission of the main light emitting module 200, the first auxiliary light emitting module 400 and the second auxiliary light emitting module 500. The controller 900 may control at least one of the first auxiliary light emitting module 400 and the second auxiliary light emitting module 500 to emit light. The controller 900 may be implemented by an arithmetic unit including a microprocessor, a memory, and the like, and since the implementation method is obvious to those skilled in the art, further detailed descriptions are omitted.

Meanwhile, in addition to such configurations, according to a third embodiment of the present invention, the tilting module 300 may be configured to be rotatable.

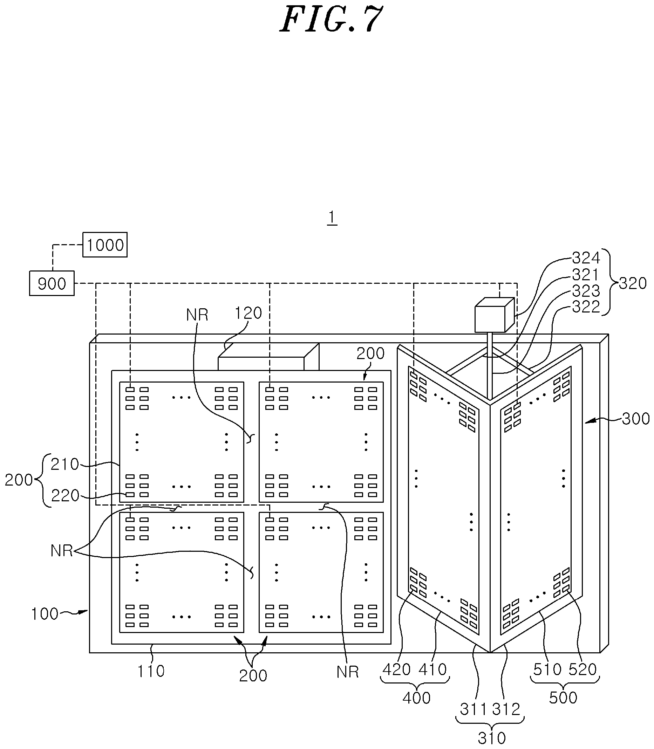

The third embodiment will be described below with reference to FIGS. 7 to 10. In describing the third embodiment of the present invention, the description will be made mainly on the difference from the above-described embodiment, and the same descriptions and reference numerals are referred to the above-described embodiment.

In the third embodiment of the present invention, the tilting module 300 may be configured to be rotatable. The tilting module 300 may be configured to be rotatable about a rotation shaft 323 extending in one direction. In addition, the tilting frame 310 may be rotated by a rotation driving unit 320. Further, the first frame part 311 and the second frame part 312 of the tilting frame 310 may be rotated at the same angle with respect to the reference position by the rotation driving unit 320. In other words, when the first frame part 311 is rotated 30 degrees to the right with respect to the reference position, the second frame part 312 is also rotated 30 degrees with respect to the reference position. However, the present invention is not limited thereto, and the first frame part 311 and the second frame part 312 may be rotated at different angles with respect to the reference position by the rotation driving unit 320. In other words, when the first frame part 311 is rotated 30 degrees to the right with respect to the reference position, the second frame part 312 may be rotated 60 degrees to the right with respect to the reference position. That is, since angles of the first frame part 311 and the second frame part 312 can be adjusted freely by the rotation driving unit 320, the viewing angle can be easily adjusted depending on the display type to be implemented.

The rotation driving unit 320 may provide a driving force for rotating the tilting frame 310. The rotation driving unit 320 may be configured to have the rotation shaft 323 extending in a direction orthogonal to an imaginary line perpendicular to the central portion of the first frame part 311 and an imaginary line perpendicular to the central portion of the second frame part 312 and to rotate the tilting frame 310 about the rotation shaft 323. The rotation driving unit 320 may include a first link member 321, a second link member 322, the rotation shaft 323, and a rotation motor 324. The first link member 321 may be a connecting member that connects the first frame part 311 and the rotating axis 323, and the second link member 322 may be a connecting member that connects the second frame part 312 and the rotation shaft 323. The rotation shaft 323 may be a shaft rotated by the rotation motor 324. As described above, the rotation shaft 323 may extend in the direction orthogonal to the imaginary line perpendicular to the central portion of the first frame part 311 and the imaginary line perpendicular to the central portion of the second frame part 312. The rotation motor 324 may be driven to rotate the tilting frame 310. The rotation motor 324 may be disposed on the rear side of the tilting frame 310.

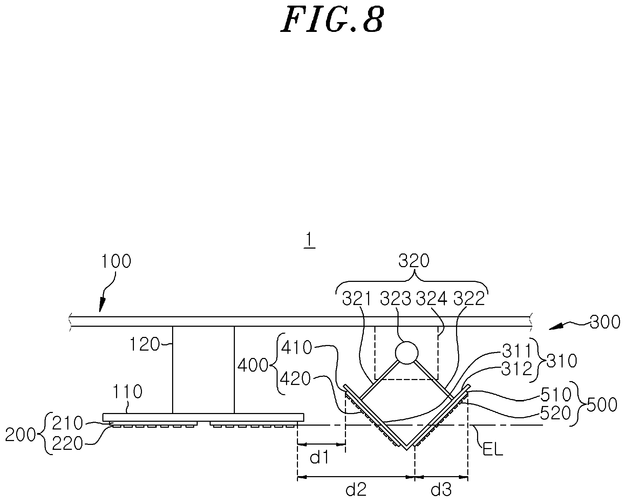

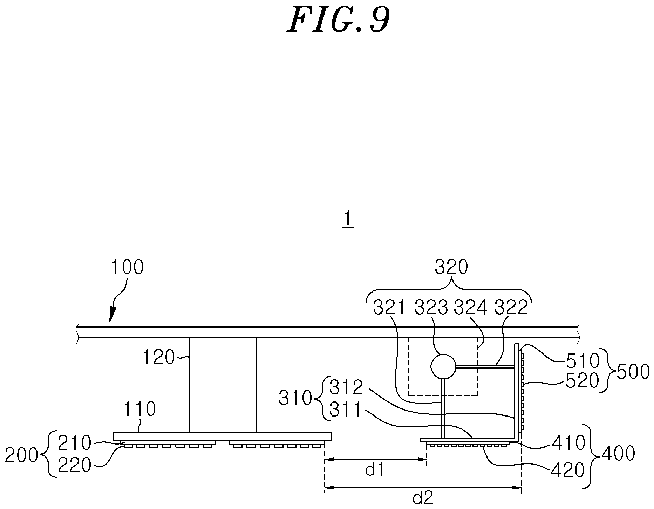

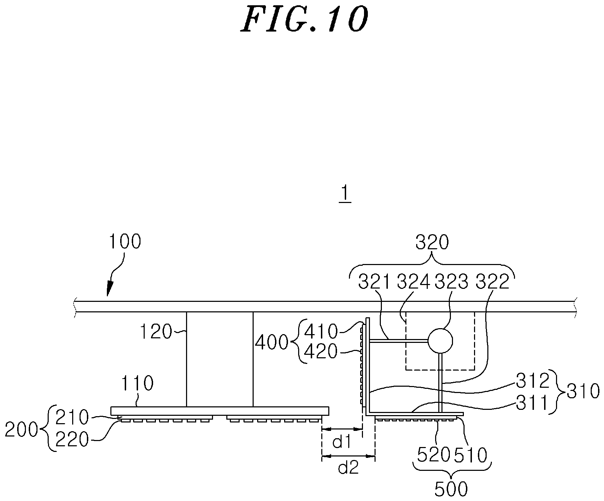

Hereinafter, the arrangements of the tilting module 300, and the first auxiliary light emitting module 400 and the second auxiliary light emitting module 500 supported by the tilting module 300 will be described with reference to FIG. 8. As shown in FIG. 8, when viewed from above in a state in which a center portion between the first auxiliary light emitting module 400 and the second auxiliary light emitting module 500 is oriented toward the front side, at least a portion of the first auxiliary light emitting module 400 and at least a portion of the second auxiliary light emitting module 500 may be disposed to protrude toward the front side beyond a reference line EL. The reference line EL may be defined as an imaginary line extending from an end of the main light emitting module support member 110 on the side of the tilting module 300 in a direction parallel to the end of the main light emitting module support member 110. In the first auxiliary light emitting module 400, a portion adjacent to the second auxiliary light emitting module 500 may protrude toward the front side beyond the reference line EL, and in the second auxiliary light emitting module 500, a portion adjacent to the first auxiliary light emitting module 400 may protrude toward the front side beyond the reference line EL. Meanwhile, the tilting frame 310 of the tilting module 300 may have a plurality of position states depending on the degree of rotation with respect to the main light emitting module support member 110. Hereinafter, with reference to FIGS. 9 and 10 in addition to FIG. 8, the positioning state and operation of the light emitting device 1 having the above configuration will be described.

Referring back to FIG. 8, a first position state may be a state in which both the first frame part 311 and the second frame part 312 of the tilting frame 310 are tilted forward. In other words, the portion of the first frame part 311 disposed adjacent to the second frame part 312 is disposed further forward than the opposite side, and the portion of the second frame part 312 disposed adjacent to the first frame part 311 may be disposed further forward than the opposite side.

When in the first position, when viewed along the direction in which the rotation shaft 323 of the rotation driving unit 320 extends (when viewed from above), the tilting frame 310 may be oriented such that the first frame part 311 is inclined toward one side with respect to an imaginary line extending in a front-rear direction, and the second frame part 312 is inclined toward the other side. Each of a front surface of the first frame part 311 and a front surface of the second frame part 312 of the tilting frame 310 forms an inclination angle with a front surface of the main light emitting module 200. In addition, the inclination angle between the front surface of the first frame part 311 and the front surface of the main light emitting module 200, and the inclination angle between the front surface of the second frame part 312 and the front surface of the main light emitting module 200 may be smaller than an angle formed by the front surface of the first frame part 311 and the front surface of the second frame part 312. An irradiation angle of light emitted from the main light emitting module 200, an irradiation angle of light emitted from the first auxiliary light emitting module 400 disposed on either one of the first frame part 311 and the second frame part 312, and an irradiation angle of light emitted from the second auxiliary light emitting module 500 disposed on the other one of the first frame part 311 and the second frame part 312 are different from each other. The sum of the difference in viewing angle between the main light emitting module 200 and the first auxiliary light emitting module 400 and the difference in viewing angle between the main light emitting module 200 and the second auxiliary light emitting module 500 can be relatively small compared to a second position state and a third position state, and can emit light three-dimensionally.

Referring to FIG. 9, in the second position state, the second frame part 312 of the tilting frame 310 may be oriented toward the rear side or lateral side, and the first frame part 311 may be oriented toward the front side. In other words, the second frame part 312 may be disposed orthogonal to the main light emitting module support member 110 or inclined at a relatively large angle with respect to the main light emitting module support member 110, and the first frame part 311 may be disposed in parallel to the main light emitting module support member 110, or inclined at a relatively small angle with respect to the main light emitting module support member 110. In the second position state, the first auxiliary light emitting module 400 disposed on the first frame part 311 may be more forward exposed than the second auxiliary light emitting module 500.

In the second position state, the difference in viewing angle between the main light emitting module 200 and the first auxiliary light emitting module 400 may be smaller than the difference in viewing angle between the main light emitting module 200 and the second auxiliary light emitting module 500. In addition, light may be emitted by using the main light emitting module 200 and the first auxiliary light emitting module 400 as main light emitting means. A separation distance d1 between the main light emitting module 200 and the first auxiliary light emitting module 400 in the second position is greater than a separation distance d1 between the main light emitting module 200 and the first auxiliary light emitting module 400 in the first position state. Accordingly, even when the light emitting elements 220, 420 and 520 are spaced at regular intervals in the light emitting modules 200, 400 and 500, due to the above-described distance d1 between the light emitting modules 200, 400, and 500, a non-light emitting area can be easily formed, and a display to be expressed can be implemented in various ways.

Referring to FIG. 10, the third position state may be a state in which the first frame part 311 of the tilting frame 310 may be oriented toward the rear side or lateral side, and the second frame part 312 is oriented toward the front side. In other words, the first frame part 311 may be disposed orthogonal to the main light emitting module support member 110 or inclined at a relatively large angle with respect to the main light emitting module support member 110, and the second frame part 312 may be disposed in parallel to the main light emitting module support member 110, or inclined at a relatively small angle with respect to the main light emitting module support member 110. In the second position state, the second auxiliary light emitting module 500 disposed on the second frame part 312 may be exposed more forward than the first auxiliary light emitting module 400. The second position state and the third position state may have phases oriented in directions opposite to each other with respect to the first position state.

In the third position state, the difference in viewing angle between the main light emitting module 200 and the first auxiliary light emitting module 400 may be greater than the difference in viewing angle between the main light emitting module 200 and the second auxiliary light emitting module 500. In addition, light may be emitted by using the main light emitting module 200 and the second auxiliary light emitting module 500 as main light emitting means. A separation distance d2 between the main light emitting module 200 and the second auxiliary light emitting module 500 in the third position state is shorter than a separation distance d2 between the main light emitting module 200 and the second auxiliary light emitting module 500 in the first position state and a separation distance d2 between the main light emitting module 200 and the second auxiliary light emitting module 500 in the second position state.

The controller 900 may control the tilting module 300 so that the tilting frame 310 of the tilting module 300 is positioned in any one of the first position state, the second position state, and the third position state. In other words, the tilting module 300 may be rotated so that the tilting frame 310 is positioned in any one of the first position sate, the second position state, and the third position state, and the rotation of the tilting module 300 is controlled by the controller 900. In addition, in a state in which the tilting frame 310 is positioned in the first position state, the second position state, or the third position state, the controller 900 may control at least one of the main light emitting module 200, the first auxiliary light emitting module 400, and the second auxiliary light emitting module 500 to generate light in a predetermined pattern.

Meanwhile, in addition to such configurations, according to a fourth embodiment of the present invention, the arrangement of the tilting frame 310 may be changed.

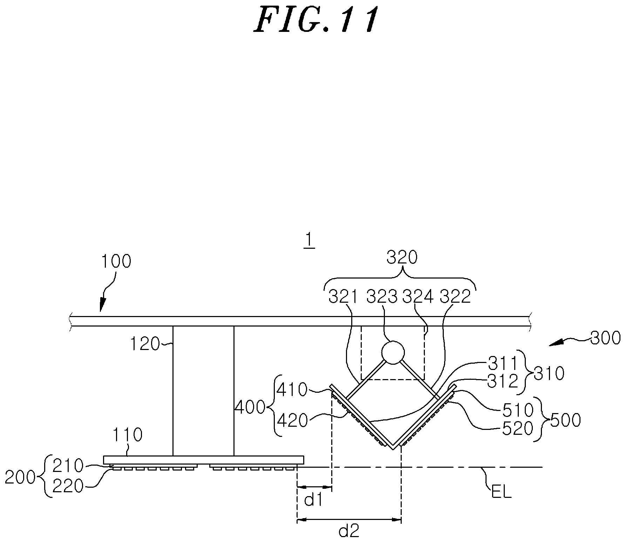

Hereinafter, the third embodiment will be described with reference to FIG. 11. In describing the third embodiment of the present invention, the description will be made mainly on the difference from the above-described embodiments, and the same descriptions and reference numerals are referred to the above-described embodiments.

Referring to FIG. 11, when viewed from above in a state in which the central portion between the first auxiliary light emitting module 400 and the second auxiliary light emitting module 500 is oriented toward the front side, at least a portion of the first auxiliary light emitting module 400 and at least a portion of the second auxiliary light emitting module 500 may be disposed behind the reference line EL. In this arrangement, the first auxiliary light emitting module 400 and the second auxiliary light emitting module 500 may be positioned further back than the main light emitting module 200. For example, when viewed along the direction in which the rotation shaft 323 extends (when viewed from above), a point crossing an imaginary line extending from an edge of the first auxiliary light emitting module 400 along the direction in which the first auxiliary light emitting module 400 is oriented and an imaginary line extending from an edge of the second auxiliary light emitting module 500 along the direction in which the second auxiliary light emitting module 500 is oriented may be disposed further back than the reference line EL. Accordingly, since the first auxiliary light emitting module 400 and the second auxiliary light emitting module 500 are not hindered by the main light emitting module 200 during rotation, the degree of freedom of rotation can be increased.

Meanwhile, in addition to such configurations, according to a fifth embodiment of the present invention, the arrangement of the tilting frame 310 may be changed differently from the fourth embodiment.

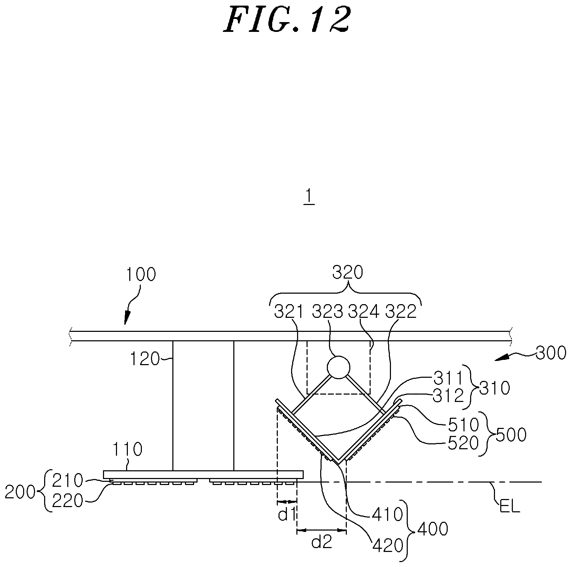

The fifth embodiment will be described with reference to FIG. 12. In describing the fourth embodiment of the present invention, the description will be made mainly on the difference from the above-described embodiments, and the same descriptions and reference numerals are referred to the above-described embodiments.

Referring to FIG. 12, in the fifth embodiment, when viewed from above in a state in which the center portion between the first auxiliary light emitting module 400 and the second auxiliary light emitting module 500 is oriented toward the front side, at least a portion of the first auxiliary light emitting module 400 and at least a portion of the second auxiliary light emitting module 500 may be disposed behind the reference line EL. In addition, in the fourth embodiment, at least a portion of the first auxiliary light emitting module 400 may be disposed behind the main light emitting module 200. That is, the main light emitting module 200 and at least a portion of the first auxiliary light emitting module 400 may overlap, and the main light emitting module 200 may overlap at least a portion of the second auxiliary light emitting module 500 depending on a rotational position.

Meanwhile, in addition to such configurations, according to a sixth embodiment of the present invention, there may be provided another member that supports the plurality of main light emission substrates 210.

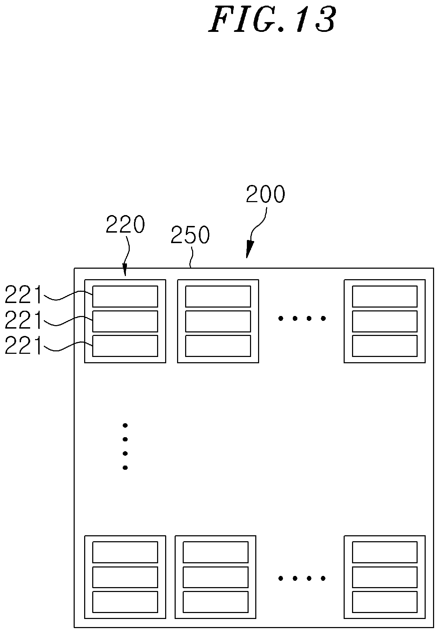

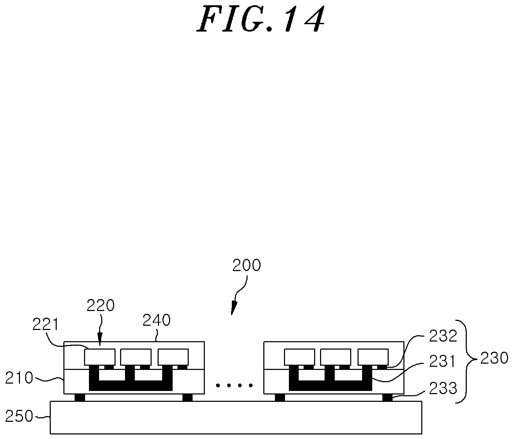

The sixth embodiment will be described with reference to FIGS. 13 and 14. In describing the sixth embodiment of the present invention, the description will be made mainly on the difference from the above-described embodiments, and the same descriptions and reference numerals are referred to the above-described embodiments.

Referring to FIGS. 13 and 14, the main light emitting module 200 may further include an auxiliary substrate 250 for main light emission that supports a plurality of substrates 210 for main light emission. The plurality of main light emission substrates 210 supported by the main light emission auxiliary substrate 250 may each support the main light emitting element 220. In other words, a plurality of main light emitting structures 221 forming one main light emitting element 220 may be supported on one main light emission substrate 210.

The main light emission common electrode 231 included in each of the plurality of main light emitting elements 220 may be individually disposed on the plurality of main light emission substrates 210. In other words, the plurality of main light emitting elements 220 of the main light emitting module 200 do not share electrodes on the main light emission substrate 210. The plurality of main light emitting elements 220 are not directly electrically connected to each other on one substrate.

The main light emission filling material 240 may cover a plurality of main light emitting elements 220 disposed on one main light emission substrate 210. When one main light emitting element 220 is disposed on one main light emission substrate 210, one main light emission filling material 240 may cover the main light emitting structure 221 forming one main light emitting element 220. In other words, the plurality of main light emitting elements 220 may be covered by a plurality of main light emission filling materials 240 that are individually provided. Accordingly, even when one of the main light emitting elements 220 does not turn on, it can be easily repaired. Meanwhile, in addition to such configurations, according to a seventh embodiment of the present invention, a packing material that covers the plurality of main light emitting elements 220 may be provided.

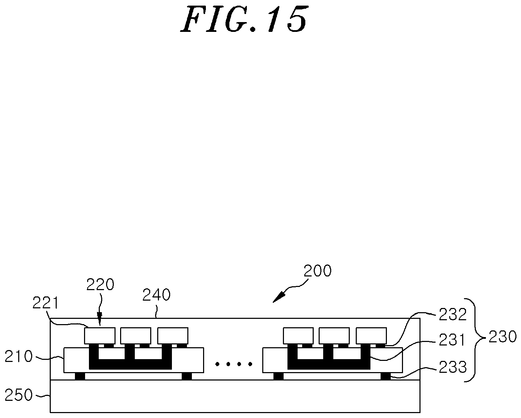

The seventh embodiment will be described with reference to FIG. 15. In describing the seventh embodiment of the present invention, the description will be made mainly on the difference from the above-described embodiments, and the same descriptions and reference numerals are referred to the above-described embodiments.

Referring to FIG. 15, the main light emission filling material 240 may cover a plurality of main light emitting elements 220. In addition, the main light emission filling material 240 may also cover the main light emission substrate 210 on which the main light emitting element 220 is disposed. In other words, the main light emission filling material 240 may cover the plurality of main light emitting elements 220 and the main light emission substrate 210 together. Accordingly, it is possible to prevent a height step from occurring on the upper surface of the main light emission filling material 240 above the plurality of main light emitting elements 220, thereby realizing a display device having a flat surface.

Meanwhile, in addition to such configurations, according to an eighth embodiment of the present invention, the main light emitting structure 221 may be covered in multiple stages.

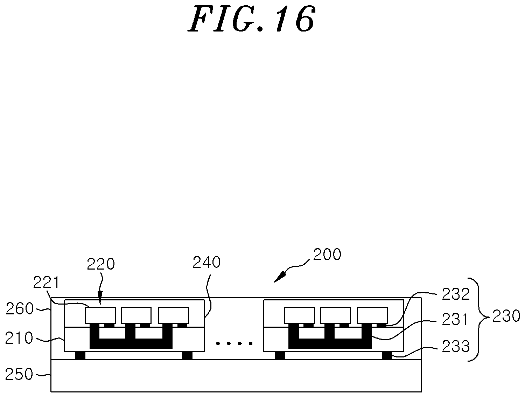

The eighth embodiment will be described with reference to FIG. 16. In describing the eighth embodiment of the present invention, the description will be made mainly on the difference from the above-described embodiments, and the same descriptions and reference numerals are referred to the above-described embodiments.

Referring to FIG. 16, the main light emitting module 200 according to the present embodiment may further include a main light emission packing material 260 that covers a plurality of main light emission filling materials 240 in addition to the main light emitting module 200 shown in the sixth embodiment. The main light emitting packing material 260 covers all of the plurality of main light emission filling materials 240, the main light emission substrate 210, and the main light emission auxiliary substrate 250 to pack the components configured on one auxiliary substrate 250 for main light emission. Accordingly, permeation of moisture into the main light emitting element 220 can be effectively prevented, and durability of the main light emitting element 220 can be improved.

The aforementioned first auxiliary light emitting module 400 may also be modified like the main light emitting module 200, which will be described below.

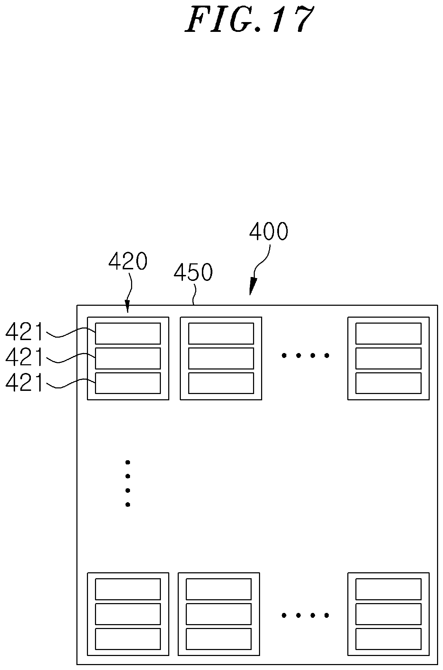

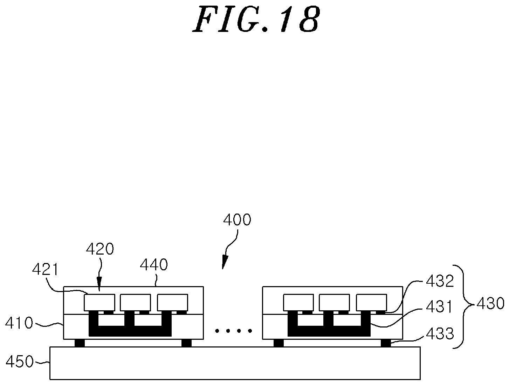

A ninth embodiment will be described with reference to FIGS. 17 and 18. In describing the ninth embodiment of the present invention, the description will be made mainly on the difference from the above-described embodiments, and the same descriptions and reference numerals are referred to the above-described embodiments.

Referring to FIGS. 17 and 18, the first auxiliary light emitting module 400 may further include a first auxiliary light emission auxiliary substrate 450 that supports a plurality of first auxiliary light emission substrates 410. Each of the plurality of first auxiliary light emission substrates 410 supported by the first auxiliary light emission auxiliary substrate 450 may support the first auxiliary light emitting element 420. In other words, a plurality of first auxiliary light emitting structures 421 forming one first auxiliary light emitting element 420 may be supported on one first auxiliary light emission substrate 410.

The common electrode 431 for first auxiliary light emission included in each of the plurality of first auxiliary light emitting elements 420 may be individually disposed on the plurality of first auxiliary light emission substrates 410. In other words, the plurality of first auxiliary light emitting elements 420 of the first auxiliary light emitting module 400 do not share electrodes on the first auxiliary light emission substrate 410. The plurality of first auxiliary light emitting elements 420 are not directly electrically connected to each other on one substrate.

The first auxiliary light emission filling material 440 may cover a plurality of first auxiliary light emitting elements 420 disposed on one first auxiliary light emission substrate 410. When one first auxiliary light emitting element 420 is disposed on one first auxiliary light emission substrate 410, one first auxiliary light emission filling material 440 may cover the first auxiliary light emitting structure 421 forming one first auxiliary light emitting element 420. In other words, the plurality of first auxiliary light emitting elements 420 may be covered by the plurality of first auxiliary light emission filling materials 440 that are individually provided.

Meanwhile, in addition to such configurations, according to a tenth embodiment of the present invention, a packing material that covers the plurality of first auxiliary light emitting elements 420 may be provided.

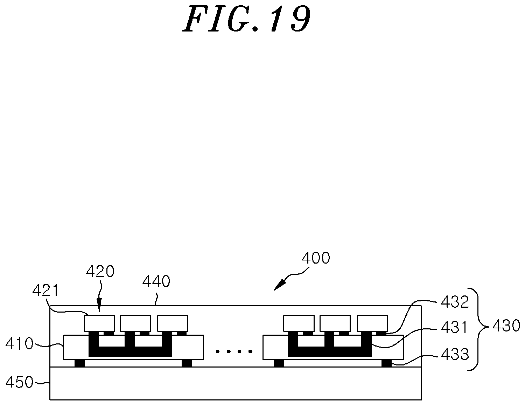

The tenth embodiment will be described with reference to FIG. 19. In describing the tenth embodiment of the present invention, the description will be made mainly on the difference from the above-described embodiments, and the same descriptions and reference numerals are referred to the above-described embodiments.

Referring to FIG. 19, the first auxiliary light emission filling material 440 may cover the plurality of first auxiliary light emitting elements 420. In addition, the first auxiliary light emission filling material 440 may also cover the first auxiliary light emission substrate 410 on which the first auxiliary light emitting element 420 is disposed. In other words, the first auxiliary light emission filling material 440 may cover the plurality of first auxiliary light emitting elements 420 and the first auxiliary light emission substrate 410 together.

Meanwhile, in addition to such configurations, according to an eleventh embodiment of the present invention, the first auxiliary light emitting structure 421 may be covered in multiple stages.

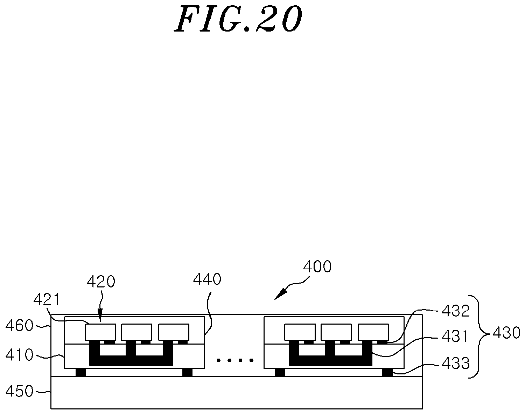

The eleventh embodiment will be described with reference to FIG. 20. In describing the eleventh embodiment of the present invention, the description will be made mainly on the difference from the above-described embodiments, and the same descriptions and reference numerals are referred to the above-described embodiments.

Referring to FIG. 20, the first auxiliary light emitting module 400 according to the present embodiment may further include a first auxiliary light emission packing material 460 that covers the plurality of first auxiliary light emission filling materials 440 in addition to the first auxiliary light emitting module 400 shown in the ninth embodiment. The first auxiliary light emission packing material 460 covers all of the plurality of first auxiliary light emission filling materials 440, the first auxiliary light emission substrate 410, and the first auxiliary light emission auxiliary substrate 450 to pack the components configured on one auxiliary substrate 450 for auxiliary light emission.

The above-described second auxiliary light emitting module 500 may also be modified like the first auxiliary light emitting module 400, which will be described below.

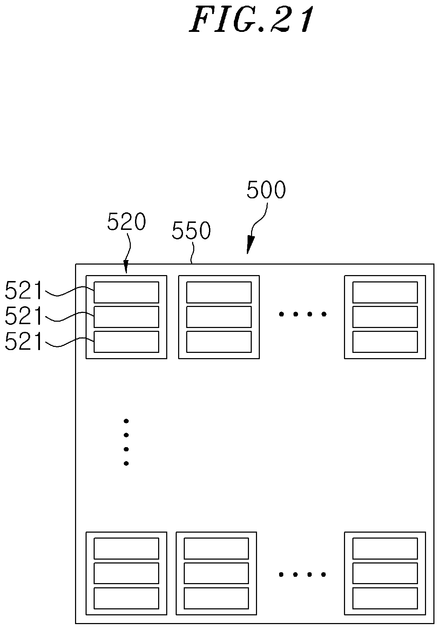

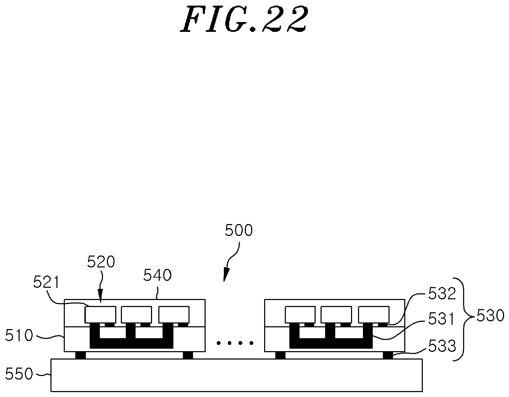

A twelfth embodiment will be described with reference to FIGS. 21 and 22. In describing the twelfth embodiment of the present invention, the description will be made mainly on the difference from the above-described embodiments, and the same descriptions and reference numerals are referred to the above-described embodiments.

Referring to FIGS. 21 and 22, the second auxiliary light emitting module 500 may further include a second auxiliary light emission auxiliary substrate 550 that supports a plurality of second auxiliary light emission substrates 510. The plurality of second auxiliary light emission substrates 510 supported by the second auxiliary light emission auxiliary substrate 550 may each support the second auxiliary light emission substrate 520. In other words, a plurality of second auxiliary light emitting structures 521 forming one second auxiliary light emitting element 520 may be supported on one second auxiliary light emission substrate 510.

The common electrode 531 for second auxiliary light emission included in each of the plurality of second auxiliary light emitting elements 520 may be individually disposed on the plurality of second auxiliary light emission substrates 510. In other words, the plurality of second auxiliary light emitting elements 520 of the second auxiliary light emitting module 500 do not share electrodes on the second auxiliary light emission substrate 510. The plurality of second auxiliary light emitting elements 520 are not directly electrically connected to each other on one substrate.

The second auxiliary light emission filling material 540 may cover a plurality of second auxiliary light emitting elements 520 disposed on one second auxiliary light emission substrate 510. When one second auxiliary light emitting element 520 is disposed on one second auxiliary light emission substrate 510, one second auxiliary light emission filling material 540 may cover the second auxiliary light emitting structure 521 forming one second auxiliary light emitting element 520. In other words, the plurality of second auxiliary light emitting elements 520 may be covered by the plurality of second auxiliary light emission filling materials 540 that are individually provided.

Meanwhile, in addition to such configurations, according to a thirteenth embodiment of the present invention, a packing material that covers the plurality of second auxiliary light emitting elements 520 may be provided.

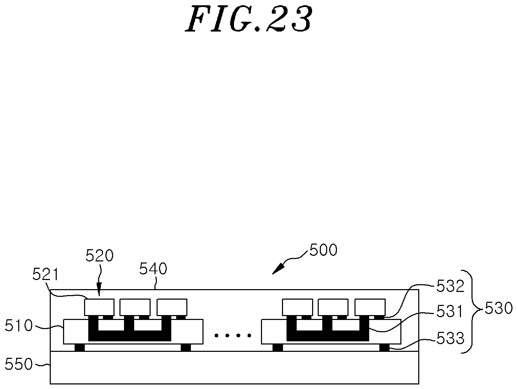

The thirteenth embodiment will be described with reference to FIGS. 23. In describing the thirteenth embodiment of the present invention, the description will be made mainly on the difference from the above-described embodiments, and the same descriptions and reference numerals are referred to the above-described embodiments.

Referring to FIG. 23, the second auxiliary light emission filling material 540 may cover a plurality of second auxiliary light emitting elements 520. In addition, the second auxiliary light emission filling material 540 may also cover the second auxiliary light emission substrate 510 on which the second auxiliary light emitting element 520 is disposed. In other words, the second auxiliary light emission filling material 540 may cover the plurality of second auxiliary light emitting elements 520 and the second auxiliary light emission substrate 510 together.

Meanwhile, in addition to such configurations, according to a fourteenth embodiment of the present invention, the second auxiliary light emitting structure 521 may be covered in multiple stages.

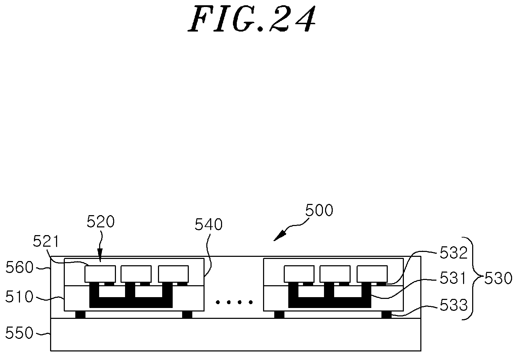

The fourteenth embodiment will be described with reference to FIGS. 24. In describing the thirteenth embodiment of the present invention, the description will be made mainly on the difference from the above-described embodiments, and the same descriptions and reference numerals are referred to the above-described embodiments.

Referring to FIG. 24, the second auxiliary light emitting module 500 according to the present embodiment may further include a second auxiliary light emission packing material 560 that covers the plurality of second auxiliary light emission filling materials 540 in addition to the second auxiliary light emitting module 500 shown in the sixth embodiment. The second auxiliary light emission packing material 560 may cover all of the plurality of second auxiliary light emission filling materials 540, the second auxiliary light emission substrate 510, and the second auxiliary light emission auxiliary substrate 550 to pack the components configured on one second auxiliary substrate 550 for auxiliary light emission.

Meanwhile, in addition to such configurations, according to a fifteenth and a sixteenth embodiment of the present invention, a reflection module 700 disposed on the tilting module 300 may be provided. The reflection module 700 may be disposed on the tilting frame 310 to reflect light. The reflection module 700 may be disposed on at least one of the first frame part 311 and the second frame part 312, may be disposed by replacing at least one of the first auxiliary light emitting module 400 and the second auxiliary light emitting module 500 described above, or may be disposed together with the first auxiliary light emitting module 400 and the second auxiliary light emitting module 500.

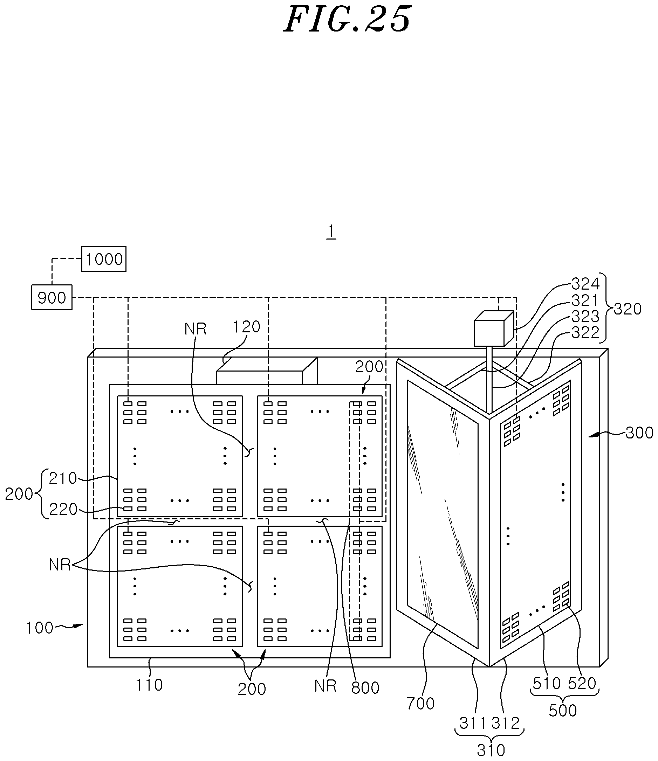

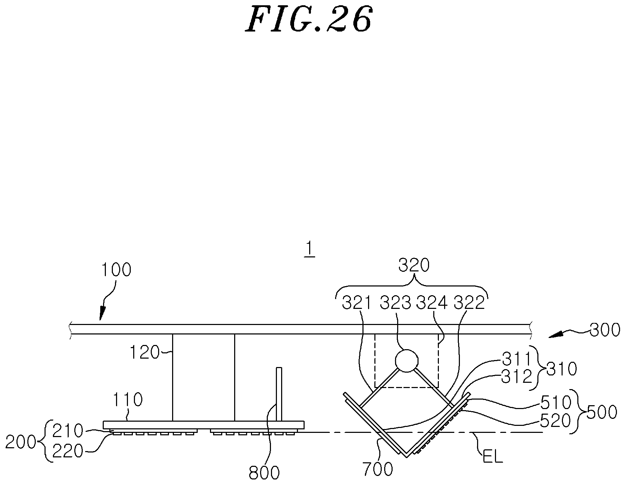

Hereinafter, the fifteenth embodiment will be described with reference to FIGS. 25 and 26. In the description of the fifteenth embodiment of the present invention, the description will be made mainly on the difference from the above-described embodiments, and the same descriptions and reference numerals are referred to the above-described embodiments.

Referring to FIGS. 25 and 26, the reflection module 700 is disposed on one side of the tilting module 300 to reflect light. The reflection module 700 may reflect light at various angles as the tilting module 300 rotates. The reflection module 700 may be, for example, a mirror. For example, the first auxiliary light emitting module 400 may be disposed on either one of the first frame part 311 and the second frame part 312, and the reflection module 700 may be disposed on the other one of the first frame part 311 and the second frame part 312. The reflection module 700 may reflect light from the outside of the light emitting device 1 or reflect light generated from the main light emitting module 200.

As the tilting frame 310 is placed in the first to third position states, the orientation angle of the reflection module 700 may vary. By changing the position state of the tilting frame 310, the reflection module 700 can reflect light at various angles.

In addition, the light emitting device 1 may further include a reflection light emitting module 800 for generating light to be reflected by the reflection module 700 so that more light can be reflected by the reflection module 700. The reflection light emitting module 800 may be disposed adjacent to the reflection module 700 disposed on the tilting module 300. For example, as shown in FIGS. 25 and 26, when the tilting module 300 is disposed on the right side of the main light emitting module 200, and the reflection module 700 is placed on the first frame portion 311 which is the left side of the tilting module 300, the reflection light emitting module 800 may be disposed at the left side of the tilting frame 310.

The reflection light emitting module 800 may be disposed on the rear side of the main light emitting module 200 and supported by the main body 100. The reflection light emitting module 800 may be disposed behind the main light emitting module 200 so as not to be exposed when the main light emitting module 200 is viewed from the front side. The reflection module 700 may reflect at least one of light generated from the reflection light emitting module 800 and light spreading laterally from the main light emitting module 200.

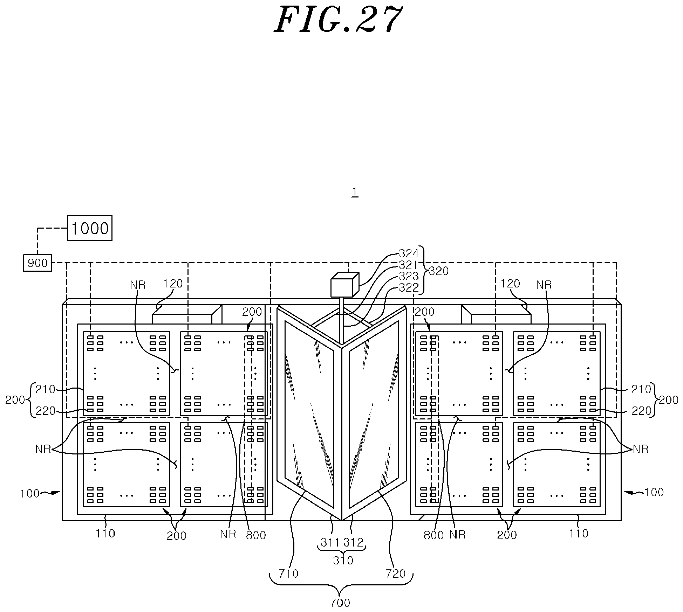

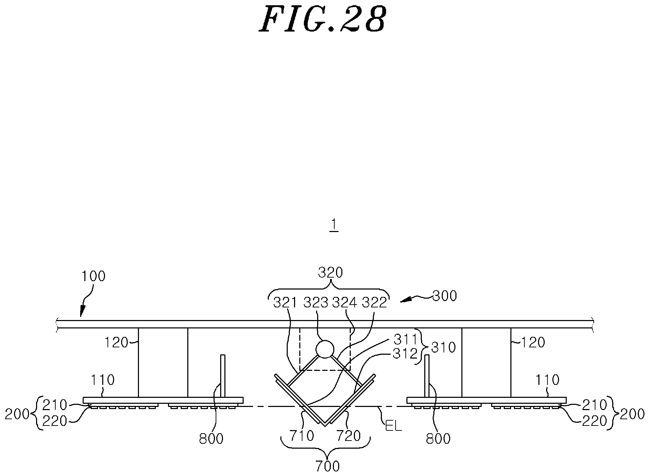

Hereinafter, the sixteenth embodiment will be described with reference to FIGS. 27 and 28. In describing the sixteenth embodiment of the present invention, the description will be made mainly on the difference from the above-described embodiments, and the same descriptions and reference numerals are referred to the above-described embodiments.

Referring to FIGS. 27 and 28, a plurality of reflection modules 700 may be provided. The plurality of reflection modules 700 may be disposed on both sides of the tilting module 300 to reflect light. The plurality of reflection modules 710 may include a first reflection module 710 and a second reflection module 720. The first reflection module 710 may be disposed on the first frame part 311 and the second reflection module 720 may be disposed on the second frame part 312. The reflection module 700 may reflect light at various angles as the tilting module 300 rotates. For example, the orientation angle of the reflection module 700 may change as the tilting frame 310 is placed in the first to third positions.

Meanwhile, in addition to such configurations, according to a seventeenth and an eighteenth embodiment of the present invention, a plurality of tilting modules 300 may be provided for one main light emitting module 200.

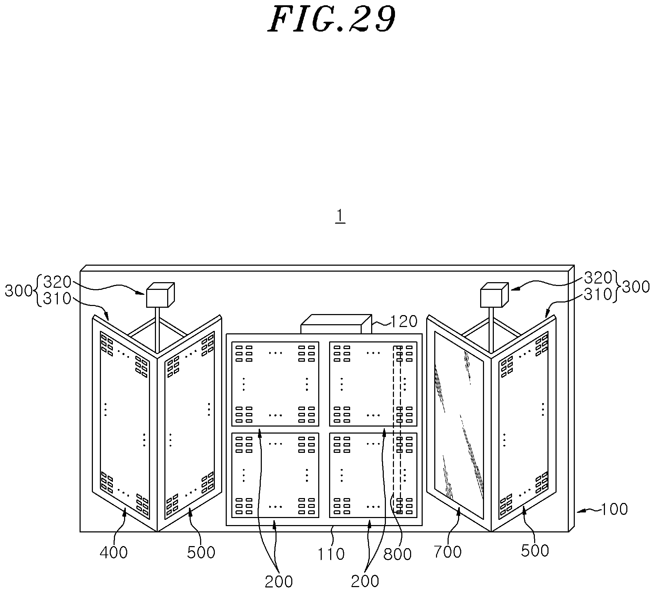

Hereinafter, the seventeenth embodiment will be described with reference to FIGS. 29 to 31. In the description of the sixteenth embodiment of the present invention, the description will be made mainly on the difference from the above-described embodiments, and the same descriptions and reference numerals are referred to the above-described embodiments.

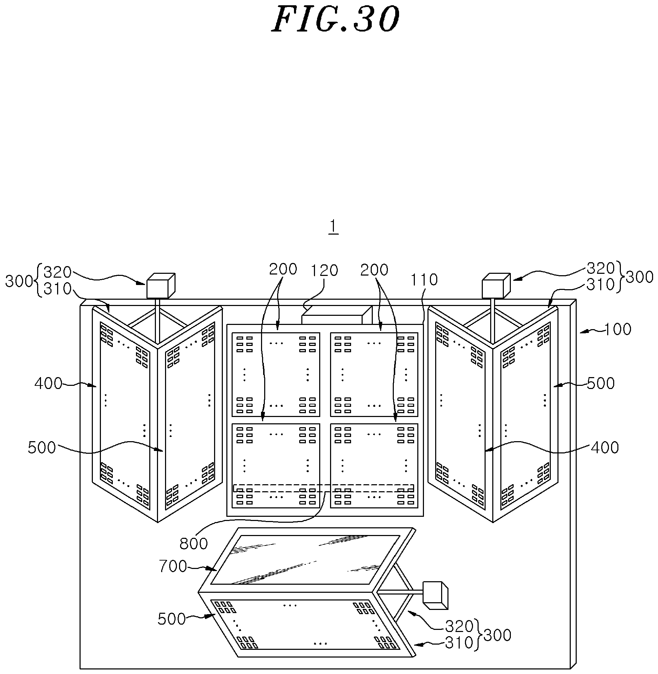

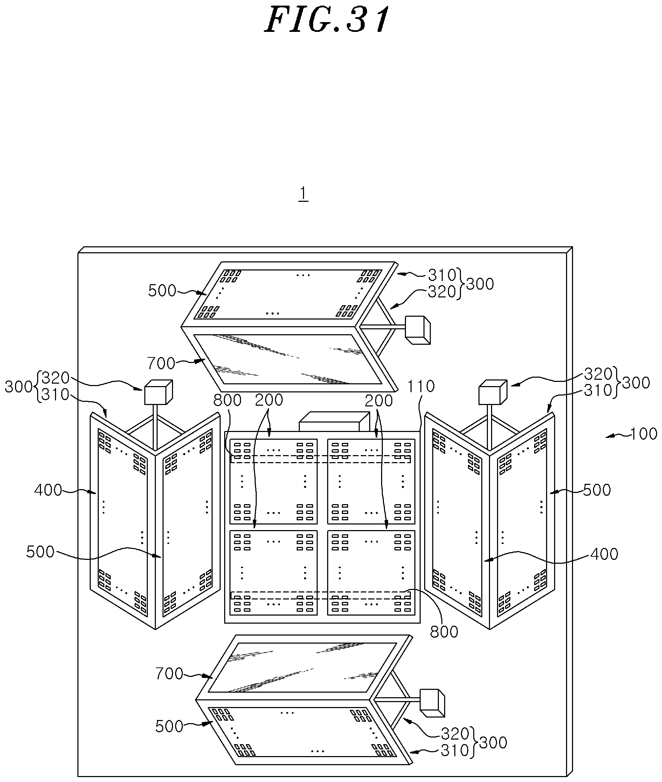

Referring to FIGS. 29 to 31, the plurality of tilting modules 300 may be provided to be disposed adjacent to one main light emitting module 200. As an example, as shown in FIG. 29, two tilting modules 300 may be disposed on both left and right sides of the main light emitting module 200, and as another example, as shown in FIG. 30, three tilting modules 300 may be disposed on the upper or lower side and both the left and right sides of the main light emitting module 200. In addition, as another example, as shown in FIG. 31, four tilting modules may be disposed on the upper, lower, left, and right sides of the main light emitting module 200.

On the plurality of tilting modules 300, only the plurality of auxiliary light emitting modules 400 and 500 may be disposed, or one or more of the plurality of auxiliary light emitting modules 400 and 500 and the plurality of reflection modules 710 and 720 may be disposed, or only the reflection modules 710 and 720 may be disposed. For example, a part of the plurality of tilting modules 300 may support only the plurality of auxiliary light emitting modules 400 and 500, another part of the plurality of tilting modules 300 may support the plurality of auxiliary light emitting modules 400 and 500, and the plurality of reflection modules 710 and 720, and the other part of the plurality of tilting modules 300 may support only the plurality of reflection modules 710 and 720. As a more specific example, the plurality of auxiliary light emitting modules 400 and 500 may be provided on the tilting module 300 disposed on the left and right sides of the main light emitting module 200 among the plurality of tilting modules 300, and the auxiliary light emitting module 400 and the reflection module 700 may be provided on the tilting module 300 disposed on the upper or lower side of the main light emitting module 200.

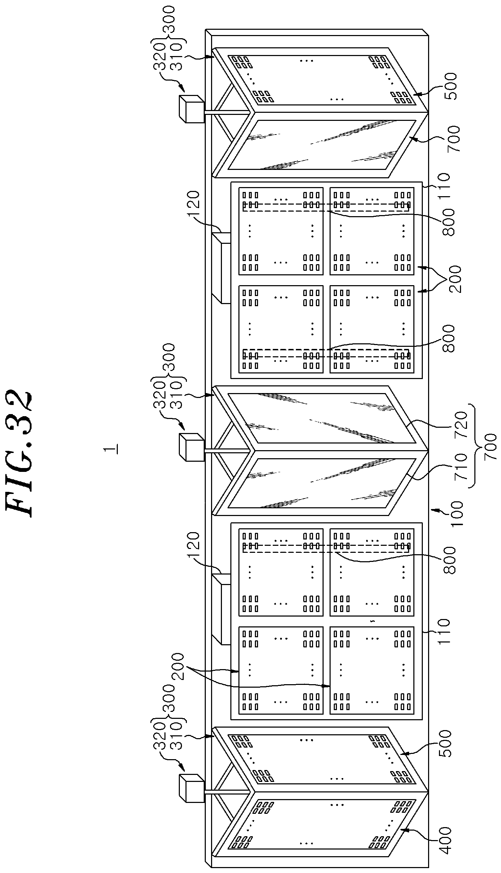

Hereinafter, the eighteenth embodiment will be described with reference to FIG. 32. In describing the eighteenth embodiment of the present invention, the description will be made mainly on the difference from the above-described embodiments, and the same descriptions and reference numerals are referred to the above-described embodiments.

Referring to FIG. 32, a plurality of main light emitting modules 200 and a plurality of tilting modules 300 may be provided. One or more tilting modules 300 may be arranged between the plurality of main light emitting modules 200. For example, the plurality of main light emitting modules 200 and the plurality of tilting modules 300 may be alternately disposed.

On the plurality of tilting modules 300, only the plurality of auxiliary light emitting modules 400 and 500 may be disposed, or one or more of the plurality of auxiliary light emitting modules 400 and 500 and the plurality of reflection modules 710 and 720 may be disposed, or only the reflection modules 710 and 720 may be disposed. For example, a part of the plurality of tilting modules 300 may support only the plurality of auxiliary light emitting modules 400 and 500, another part of the plurality of tilting modules 300 may support the plurality of auxiliary light emitting modules 400 and 500 and the plurality of reflection modules 710 and 720, and the other part of the plurality of tilting modules 300 may support only the plurality of reflection modules 710 and 720. As a more specific example, the reflection module 700 may be provided on the tilting module 300 disposed between the main light emitting modules 200 among the plurality of tilting modules 300, and the plurality of auxiliary light emitting modules 400 and 500, or the auxiliary light emitting module 400 and the reflection module 700 may be provided on the tilting module 300 disposed on the left and right sides of the main light emitting module 200 not between the main light emitting modules 200.

The examples of the present invention have been described above as specific embodiments, but these are only examples, and the present invention is not limited thereto, and should be construed as having the widest scope according to the technical spirit disclosed in the present specification. A person skilled in the art may combine/substitute the disclosed embodiments to implement a pattern of a shape that is not disclosed, but it also does not depart from the scope of the present invention. In addition, those skilled in the art can easily change or modify the disclosed embodiments based on the present specification, and it is clear that such changes or modifications also belong to the scope of the present invention.

## Claims

1. A light emitting device comprising:
a main body;
a main light emitting module which is disposed on the main body and generates light;
a tilting module including a tilting frame which has a first frame part and a second frame part forming an angle with each other, and is disposed on one side of the main light emitting module;
a first auxiliary light emitting module disposed on the first frame part to generate light; and
a second auxiliary light emitting module disposed on the second frame part to generate light.

2. The light emitting device of claim 1, wherein the main light emitting module includes a main light emission substrate disposed on the main body and one or more main light emitting elements disposed on the main light emission substrate.

3. The light emitting device of claim 2, wherein the main light emitting module includes a plurality of main light emitting modules, and a non-emission area where no light is generated is formed between the plurality of main light emitting modules.

4. The light emitting device of claim 2, wherein the one or more main light emitting elements include a plurality of main light emitting structures and a main light emission electrode,
wherein each of the plurality of main light emitting structures includes one or more conductive-type semiconductor layer and an electrode layer, and
wherein the main light emission electrode is electrically connected to the electrode layer included in each of the plurality of main light emitting structures.

5. The light emitting device of claim 1, wherein the first auxiliary light emitting module includes a first auxiliary light emission substrate disposed on the first frame part, and one or more first auxiliary light emitting elements disposed on the first auxiliary light emission substrate.

6. The light emitting device of claim 5, wherein the one or more first auxiliary light emitting elements are configured to generate light of a different wavelength from that of the one or more main light emitting elements included in the main light emitting module, or configured to have a different lamination structure from that of the one or more main light emitting elements.

7. The light emitting device of claim 1, wherein the second auxiliary light emitting module includes a second auxiliary light emission substrate disposed on the second frame part, and one or more second auxiliary light emitting elements disposed on the second auxiliary light emission substrate.

8. The light emitting device of claim 1, wherein the tilting module further includes a rotation driving unit configured to provide a driving force for rotating the tilting frame,
the rotation driving unit includes a rotation shaft extending in a direction orthogonal to an imaginary line perpendicular to a central portion of the first frame part and an imaginary line perpendicular to a central portion of the second frame part, and
the rotation driving unit is configured to rotate the tilting frame about the rotation shaft.

9. The light emitting device of claim 8, wherein when viewed from a front side, a width of the tilting module in a left-right direction is smaller than a width of the main light emitting module in the left-right direction.

10. The light emitting device of claim 8, further comprising a controller for controlling at least one of the main light emitting module, the first auxiliary light emitting module, and the second auxiliary light emitting module to emit light, or controlling the rotation driving unit to rotate the tilting frame.

11. The light emitting device of claim 10, wherein the controller controls the tilting module so that the tilting frame is positioned in a first position state in which a front surface of the first frame part and a front surface of the second frame part each form an inclination angle with a front surface of the main light emitting module, a second position state in which one of the front surface of the first frame part and the front surface of the second frame part is parallel to the front surface of the main light emitting module, or a third position state in which the other one of the front surface of the first frame part and the front surface of the second frame part is parallel to the front surface of the main light emitting module.

12. The light emitting device of claim 11, wherein in the first position state, the inclination angle between the front surface of the first frame part and the front surface of the main light emitting module and the inclination angle between the front surface of the second frame part and the front surface of the main light emitting module are smaller than an angle formed by the front surface of the first frame part and the front surface of the second frame part.

13. The light emitting device of claim 11, wherein in the first position state, a connection portion of the first frame part and the second frame part is protruded forward or retracted backward by a predetermined distance from an imaginary reference line extending from the front surface of the main light emitting module to the connection portion of the first frame part and the second frame part.

14. A light emitting device comprising:
a main body;
a main light emitting module which is disposed on the main body and generates light;
a tilting module including a tilting frame which has a first frame part and a second frame part forming an angle with each other, and is disposed on one side of the main light emitting module;
an auxiliary light emitting module disposed on one of the first frame part and the second frame part to emit light; and
a reflection module disposed on the other one of the first frame part and the second frame part to reflect light.

15. The light emitting device of claim 14, wherein the auxiliary light emitting module includes an auxiliary light emission substrate disposed on one of the first frame part and the second frame part, and one or more auxiliary light emitting elements disposed on the auxiliary light emission substrate.

16. The light emitting device of claim 14, further comprising a reflection light emitting module disposed on the main body to irradiate light to the reflection module.

17. The light emitting device of claim 14, wherein the tilting module further includes a rotation driving unit configured to provide a driving force for rotating the tilting frame, and
wherein the light emitting device further comprises a controller for controlling at least one of the main light emitting module and the auxiliary light emitting module to emit light, or controlling the rotation driving unit to rotate the tilting frame.

18. A light emitting device comprising:
a main body;
a main light emitting module which is disposed on the main body and generates light;
a tilting module including a tilting frame which has a first frame part and a second frame part forming an angle with each other, and is disposed on one side of the main light emitting module; and
a reflection module disposed on each of the first frame part and the second frame part to reflect light.

19. The light emitting device of claim 18, further comprising a reflection light emitting module disposed on the main body to irradiate light to the reflection module.

20. The light emitting device of claim 18, wherein the tilting module further includes a rotation driving unit configured to provide a driving force for rotating the tilting frame, and
wherein the light emitting device further comprises a controller for controlling the main light emitting module to emit light, or controlling the rotation driving unit to rotate the tilting frame.
